**Europäisches Patentamt**

**European Patent Office**

**Office européen des brevets**

(19)

(11) Numéro de publication: **0 011 020**
**A1**

## (12) DEMANDE DE BREVET EUROPEEN

(21) Numéro de dépôt: **79400783.1**

(22) Date de dépôt: **23.10.79**

(51) Int. Cl.³: **H 05 K 13/00,** H 01 L 21/68, G 05 D 1/00

(30) Priorité: **31.10.78 FR 7830894**

(43) Date de publication de la demande: **14.05.80**
**Bulletin 80/10**

(84) Etats contractants désignés: **AT BE CH DE GB IT LU NL SE**

(71) Demandeur: **SOCIETE D'ETUDES RECHERCHES ET CONSTRUCTIONS ELECTRONIQUES SERCEL, Avenue du Bel Air Zone Industrielle, F-44470 Carquefou (FR)**

(72) Inventeur: **Bodin, Jacques, "Le Corleveau", F-44115 Basse Goulaine (FR)**

(74) Mandataire: **Corre, Jacques et al, Cabinet Regimbeau 26, Avenue Kléber, F-75116 Paris (FR)**

(54) **Ajustement automatique de la position d'une pièce entre deux butées.**

(57) L'invention concerne l'ajustement de la position d'une pièce entre deux butées.

Une buse aspirante 13 vient en prise sur une pièce 12 logée dans l'alvéole 14 d'un support 11, pour déplacer cette pièce avec lui, sauf à glisser sur la pièce 12 lorsque celle-ci vient au contact de l'une des butées 16 et 17. On imprime à la buse 13 un mouvement dont la composante selon l'axe 20 passant par les butées est une translation alternative. L'amplitude totale de cette translation décroît de manière à couvrir sensiblement l'intervalle (L-Amax, L-Amin), où L est la distance entre les butées 16 et 17, tandis que Amax et Amin sont les valeurs maximale et minimale de la dimension de la pièce 12 dans la direction 20.

Application notamment au centrage d'un composant électronique dans un alvéole.

## Ajustement automatique de la position d'une pièce entre deux butées.

La présente invention concerne l'ajustement de la position d'une pièce entre deux butées, et s'applique notamment à la mise en place automatique des composants électroniques.

En raison de la complexité croissante des circuits dans l'appareillage électronique, les opérations de mise en place et d'interconnexion des composants qui forment ces circuits prennent une importance considérable. Or, pour de nombreux composants, les tolérances dimensionnelles de fabrication sont larges, alors que la technologie de câblage - circuit imprimé par exemple - suppose un positionnement précis des composants. Pour automatiser complètement la mise en place des composants, il faut donc tout d'abord ajuster automatiquement la position des composants, et ce, malgré leurs tolérances dimensionnelles.

La présente invention fournit un moyen particulièrement simple et efficace pour ce faire. Elle s'applique de manière générale à tout genre de pièce de géométrie générale connue, dont on désire ajuster la position.

Pour ajuster la position dans une direction donnée, on place la pièce entre deux butées espacées, qui intersectent cette direction de préférence sensiblement à angle droit. Un angle différent peut être cependant envisagé pour certaines géométries particulières de pièces.

Dans une définition élémentaire de l'invention, on prévoit un organe mobile ou tête de prise, apte à venir en prise sur la pièce pour la déplacer avec lui, sauf à glisser sur la pièce lorsque celle-ci vient au contact de l'une des butées ; et l'on imprime à cet organe mobile un mouvement dont la composante selon l'axe passant par les butées est une translation alternative présentant une amplitude totale proche du jeu total de la pièce entre les butées.

L'invention offre la plénitude de ses avantages lorsque la pièce présente, dans la direction passant par les butées, une dimension A comprise dans un intervalle prédéterminé (Amin, Amax) -avec Amax au plus égale à la distance L entre les butées suivant la même direction-. On donne alors à la translation alternative une amplitude totale décroissante, couvrant l'intervalle (L-Amax, L-Amin).

Pour ajuster, en même temps ou non, la position de la pièce dans une ou plusieurs autres directions, on prévoit au moins une seconde paire de butées espacées, situées de part et d'autre de la pièce et agencées pour définir une seconde direction axiale non parallèle à celle qui passe par les premières butées. La composante selon la seconde direction axiale du mouvement imprimé à l'organe mobile est alors elle aussi une translation alternative, présentant une amplitude totale proche du jeu total de la pièce entre les deux butées de la seconde paire.

Là encore, l'invention apparaît pleinement lorsque la pièce présente, dans la seconde direction passant par les deux butées de la seconde paire, une dimension comprise dans un intervalle prédéterminé (Bmin, Bmax), dont la limite supérieure Bmax est au plus égale à la distance M entre les deux secondes butées ; la seconde composante de translation alternative présente à son tour une amplitude totale décroissante, couvrant l'intervalle (M-Bmax, M-Bmin).

De façon à priori surprenante, la demanderesse a observé qu'au terme du mouvement, lorsque l'organe mobile est revenu à sa position initiale, le composant se trouve sensiblement centré entre les butées, dans chaque direction.

Après cette observation, elle a remarqué que la précision de centrage est définie par l'écart entre l'amplitude totale de la translation alternative et le jeu total de la pièce entre les butées. Avec la translation d'amplitude décroissante selon l'invention, la précision de centrage est définie par l'écart maximum d'amplitude totale entre deux cycles adjacents de translation alternative.

Selon une autre caractéristique de l'invention, l'amplitude totale de translation alternative décroît par pas.

Pour certaines applications, l'organe mobile déplace finalement la pièce d'une distance prédéterminée afin de l'amener à la position désirée.

Pour d'autres applications, l'organe mobile effectue ensuite un mouvement prédéterminé pour transférer la pièce à un autre emplacement, et le point de prise initiale de l'organe mobile sur la pièce est choisi, par référence aux butées, d'après la position finale désirée de l'organe mobile sur la pièce.

Dans un mode de réalisation préférentiel de l'invention, l'organe mobile est d'un type capable de créer entre lui-même et la pièce une force non parallèle à la direction axiale, tel qu'une buse d'aspiration, une tête à électro-aimant, ou une tête de gravité.

Avantageusement, les butées sont définies par les bords d'un alvéole de fond plat, logeant une pièce généralement plate, l'organe mobile s'applique sur la pièce avec une force non parallèle à la direction axiale, force que la pièce transmet au fond de l'alvéole, et la surface du fond de l'alvéole est choisie pour avoir vis-à-vis de la pièce des caractéristiques de frottement inférieures à celles de l'organe mobile sur la pièce.

Selon une autre caractéristique de l'invention, le moyen qui déplace l'organe mobile comprend au moins un moteur pas à pas et des moyens de commandes associés.

D'autres caractéristiques et avantages de l'invention apparaîtront à la lecture de la description détaillée qui va suivre, faite en référence aux dessins annexés, sur lesquels :

- la figure 1 est une vue en coupe schématique illustrant un composant électronique logé dans un alvéole d'un support ; et

- la figure 2 est un diagramme temporel illustrant les 4 étapes d'un cycle de translation alternative selon la présente invention.

La description détaillée qui va suivre est située dans le cadre de l'ajustement de la position de composants électroniques. Il est clair que de nombreuses autres applications peuvent être envisagées.

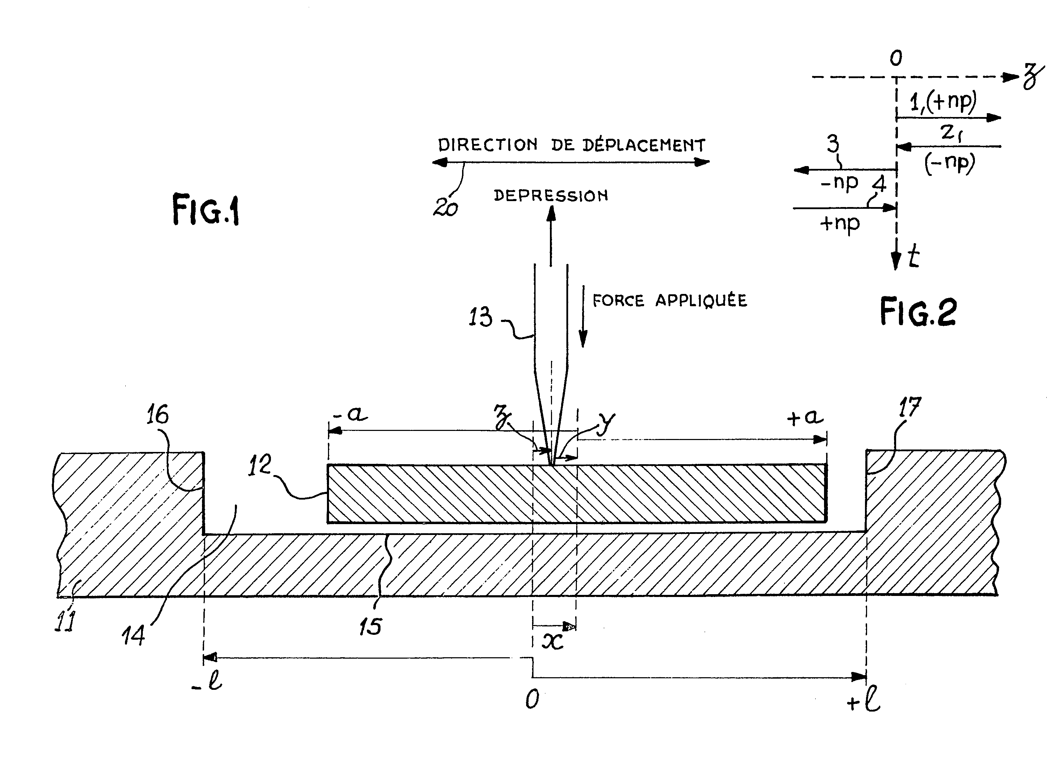

Sur la figure 1, un support 11 comporte un alvéole logeant un composant électronique 12. Le support peut faire partie d'une installation de mise en place de composants sur des substrats -tels les circuits à couches épaisses-, ou encore par exemple être un organe de stockage de composants vérifiés et rangés en position connue. L'alvéole, désigné par la référence 14, comporte sur la figure 1 un fond 15 généralement plat et deux bords 16 et 17 de préférence sensiblement perpendiculaires au fond.

Bien entendu, l'alvéole se complète d'autres bords, non représentés, dont la disposition générale correspond à la forme générale du composant. Par ailleurs, pour des composants non plats, on peut envisager un fond non plat 15, adapté à la forme du composant, pourvu que ce fond permette une translation dans le plan de la figure, parallèlement à la direction 20.

Dans de nombreux cas, les composants sont plats et de forme rectangulaire, et l'alvéole vu de dessus est également de forme rectangulaire, avec les deux bords 16 et 17 représentés, et deux autres bords perpendiculaires non représentés.

On considèrera tout d'abord le cas d'un ajustement de la position du composant dans une seule direction (20 sur la figure 1).

Une buse mobile à dépression 13 est appliquée sur le composant, de manière à le déplacer avec elle, sauf lorsque le composant vient au contact de l'une des butées 16 et 17, auquel cas la buse glisse sur le composant.

Selon l'invention, on applique à la buse un mouvement de translation alternative dans la direction 20. Très avantageusement un moteur pas à pas (non représenté) est actionné par une logique de commande (non représentée) pour produire cette translation alternative. Le pas du mouvement de la buse est p, et le nombre de pas commandé est n.

Les autres notations sont les suivantes :
- 0 est l'origine des abscisses (point médian entre les butées 16 et 17) ;
- les butées 16 et 17 sont donc aux abscisses - 1 et + 1 respectivement ; la distance entre les butées L est égale à 2l ;
- la dimension du composant dans la direction 20 est A = 2a ;
- l'abscisse du centre du composant est x, et celle de la buse est z ; y = x - z désigne la distance algébrique entre le centre du composant et la buse.

La figure 2 illustre les quatre étapes (1 à 4) d'un cycle du mouvement imprimé à la buse 13. Chaque étape implique un déplacement d'amplitude np, et l'abscisse z de la buse évolue de la manière suivante : (l'indice i indiquant dans la suite qu'une variable est prise à la fin de l'étape).

$$z_1 = np$$
$$z_2 = z_1 - np = 0$$
$$z_3 = z_2 - np = - np$$
$$z_4 = z_3 + np = 0$$

En plus des notations de la figure 1, on désigne par J la différence positive 1 - a ; $x_0$ est la valeur algébrique initiale de l'excentrement de la pièce, tandis que $x_4$ est sa valeur algébrique finale après la quatrième étape. On note aussi $|x_0|$ et $|x_4|$ les valeurs absolues ou amplitudes (sans le signe) de l'excentrement initial $x_0$, et de l'excentrement final $x_4$, respectivement.

La demanderesse a observé que l'excentrement final $x_4$ dépend de la relation entre np, J et $x_0$ :

1) si $np \leqslant J - |x_0|$, l'état final de la pièce est le même que son état initial (aucun glissement).

2) si $J - |x_0| < np \leqslant J$, il y a glissement à la première étape si $x_0$ est positif, ou à la troisième étape si $x_0$ est négatif. Dans les deux cas, on a finalement $|x_4| = J - np$, $x_4$ conservant le même signe que $x_0$.

3) si $J < np \leqslant 2J$, il y a glissement aux première et troisième étapes. L'état final est $x_4 = np - J$ (toujours positif).

4) Enfin, si $np > 2J$, il y a glissement à chacune des quatre étapes, et $x_4 = J$.

A un composant électronique choisi au hasard dans un lot de fabrication, il correspond une valeur de J inconnue, dont on sait simplement qu'elle est comprise entre un minimum k, et un maximum m au plus égal à 1 (lorsque le composant entre juste dans son alvéole).

En appliquant à la buse une translation np d'amplitude décroissante depuis une valeur sensiblement supérieure ou égale à 1 - k, jusqu'à une valeur sensiblement égale ou inférieure à 1 - m, il y aura un cycle où np est pour la dernière fois égal ou légèrement supérieur à la valeur de J (inconnue). On pose qu'à ce moment np = J + d, avec d très petit positif. Ce cycle correspond au cas 3) ci-dessus.

A la fin du cycle, on obtient $x_4 = d$, très petit. Au cycle suivant, (s'il y en a un) on part avec $x_0 = d$, et maintenant np inférieur à J ; on pose np = J - d'(d' positif également très petit). Ce cycle suivant correspond au cas 2), avec $x_0 > 0$. Si $d' < d$, on aura alors une position finale $x_4 = d'$ positif inférieur à d.

Si d' $>$ d, il ne se passe rien (cas 1). Aux cycles ultérieurs, il ne peut non plus rien se passer (cas 1) :
après chaque cycle, ou chaque cycle, le centre du composant se retrouve à l'abscisse d, ou d' positive. On
notera que du fait de la possibilité symétrique de centrage autour de la valeur np = J, l'erreur maximale de
centrage est égale au demi-pas de décroissance de l'amplitude np.

Donc, pour un composant choisi au hasard et de
demi-longueur a comprise entre k et m, si l'on fait décroître l'amplitude de translation alternée np depuis
une valeur supérieure ou égale à 1 - k jusqu'à une valeur
inférieure ou égale à 1 - m, il y aura nécessairement un
cycle alterné où np est voisin de J = 1 - a, et au terme
duquel le composant est sensiblement centré entre les
deux butées, après quoi il revient toujours en cette
position centrée au terme de chaque cycle ou demi-cycle.

La demanderesse a observé que si l'écart maximum
entre deux cycles adjacents de translation alternée est
e, tandis que l'ensemble des cycles couvre la gamme d'amplitude allant de 1 - k à 1 - m, tout composant de demi-
longueur comprise entre k et m se trouvera centré avec
une erreur de centrage au plus égale à e. En écrivant
Amax = 2 m, Amin = 2k et L = 21, on retrouve la condition précitée que l'amplitude totale de translation
alternative couvre tout l'intervalle (L - Amin, L - Amax).

Dans la pratique, de nombreux mouvements de
translation alternée, d'amplitude décroissante sur tout
l'intervalle (1 - k, 1 - m) conviennent pour la mise en
oeuvre de l'invention. On peut donc utiliser par exemple
une translation alternative dont l'amplitude décroît
selon une loi logarithmique. Mais, dans ce cas, c'est la plus grande différence entre les amplitudes de deux cycles consécutifs qui définit l'erreur de position.

La demanderesse préfère actuellement utiliser une translation alternative d'amplitude décroissante qui satisfasse les deux conditions suivantes :

- l'écart entre les amplitudes de deux cycles consécutifs reste sensiblement constant (décroissance d'amplitude en progression arithmétique) ;

- dans chaque cycle, l'alternance positive du mouvement et l'alternance négative du mouvement ont des amplitudes aussi proches que possible.

Dans le mode de réalisation préférentiel de l'invention, le mouvement de l'organe mobile est déterminé par une vis sans fin actionnée par un moteur pas à pas, et l'on obtient la translation alternative en commandant le moteur pas à pas pour qu'il effectue une série de cycles selon la figure 2, avec des amplitudes $n_1 p$, $n_2 p$, $n_3 p$... $n_i p$, où $n_i$ représente le nombre de pas commandés et p l'avance de l'organe mobile pour un pas du moteur pas à pas.

EXEMPLE

Soient des composants électroniques dont la longueur varie entre Amax = 60/1000 de pouce (1,5 mm environ) et Amin = 40/1000 de pouce (1 mm environ). Le cas est fréquent, et l'on notera que la longueur des composants varie de 50%. Le pas de l'organe mobile est p = 2,5/1000 de pouce (environ 0,064 mm). L'alvéole est de dimension L = Amax.

Le moteur pas à pas fait successivement quatre cycles tels que définis à la figure 2, avec $n_1 = 4$, $n_2 = 3$, $n_3 = 2$ et $n_4 = 1$, respectivement. On vérifie que

$$n_1 p = 10/1000 = \frac{L - Amin}{2} = 1 - a = J ;$$

de son côté, l'écart d'amplitude entre deux cycles adjacents est p = 2,5/1000 de pouce.

Finalement, l'excentrement **x** du composant est au minimum zéro, et au maximum 1,25/1000 de pouce, avec une valeur moyenne de 0,625 millièmes de pouce (moins de 1,6 centième de millimètre).

Un centrage de cette précision s'est avéré largement suffisant pour permettre ultérieurement une manipulation automatique du composant, qui peut se faire à l'aide de l'organe mobile lui-même.

On remarquera par ailleurs que l'opération de centrage ne nécessite que quatre cycles du moteur pas à pas, qui peuvent être effectués en une fraction de seconde.

Si l'on augmente le nombre de cycles en diminuant corrélativement l'écart d'amplitude entre deux cycles consécutifs, on peut obtenir un positionnement aussi précis que l'on veut.

Dans ce qui précède, on a indiqué que la gamme d'amplitudes décroissantes de translation alternée devait descendre d'une valeur supérieure ou sensiblement égale à 1 - k (ou L - Amin pour l'amplitude totale) à une valeur inférieure ou sensiblement égale à 1 - m (ou L - Amax pour l'amplitude totale). Le mot sensiblement couvre le cas où l'amplitude ne diffère de la limite considérée qu'à l'erreur admissible e près pour 1 - k et 1 - m, ou à deux fois l'erreur admissible près pour L - Amin et L - Amax.

L'exemple ci-dessus montre clairement un cas où l'amplitude basse L - Amax est nulle, mais où la translation alternée s'arrête à L - Amax + 2e = 0 + 2,5/1000 de pouce, puisque 2e est la différence d'amplitude entre deux cycles consécutifs lorsque la décroissance se fait en progression arithmétique.

Une fois le composant centré, on peut le mettre dans toute position désirée en le déplaçant avec la buse d'une distance prédéterminée.

D'autres applications supposent que le composant soit emmené avec la buse. En mettant initialement la buse en prise avec le composant au droit de l'origine O, la buse se retrouve finalement, elle aussi, au centre du composant. On peut obtenir une position de buse différente en faisant varier celle-ci avant ou après l'ajustement de position automatique selon l'invention.

Toutefois, il faut que la position initiale d'amenée de la buse se situe à coup sûr sur le composant. Connaissant la fourchette (Amin, Amax) des dimensions de celui-ci, il est aisé d'y arriver, en une seule opération si Amin L/2, ou en deux opérations si Amin L/2 (un essai près de la butée 16, et un essai près de la butée 17).

Au lieu d'une buse d'aspiration, on peut utiliser une tête de prise à électroaimant, ou même une tête de prise agissant par son seul poids et la force d'appui à laquelle elle est soumise. Dans ce dernier cas, le composant est soumis au poids de la buse, à la force d'appui et à son propre poids. On choisira le matériau du fond de l'alvéole et celui de la buse de manière que les caractéristiques de frottement composant-alvéole soient largement inférieures à celles composant-buse.

Avec une tête d'aspiration, ou une tête à électroaimant, il y a une force supplémentaire entre la tête et le composant, que l'on ne retrouve pas entre composant et alvéole. Il n'est donc pas impératif que la condition de frottement ci-dessus soit respectée, mais il y a avantage à tenir compte du frottement, en liaison avec la différence entre les forces d'interaction tête-composant et les forces d'interaction composant-alvéole.

La présente invention a été décrite en détail pour une seule direction de mouvement. Bien entendu, elle s'applique aussi bien avec deux directions de mouvement non parallèles. Avec un organe de prise qui suffit à lui seul pour tenir le composant entre les butées, on peut aussi envisager un ajustement de position suivant plus de deux directions non parallèles entre-elles.

0011020

## REVENDICATIONS

1 - Dispositif d'ajustement de la position d'une pièce se trouvant entre deux butées espacées, caractérisé par le fait qu'il comporte :

- un organe mobile, apte à venir en prise sur la pièce pour la déplacer avec lui, sauf à glisser sur la pièce lorsque celle-ci vient au contact de l'une des butées, et

- un moyen capable d'imprimer à l'organe mobile un mouvement dont la composante selon l'axe passant par les butées est une translation alternative, présentant une amplitude totale proche du jeu total de la pièce entre les deux butées.

2 - Dispositif selon la revendication 1, dans lequel la pièce présente, dans la direction passant par les deux butées, une dimension comprise dans un intervalle prédéterminé (Amin, Amax) dont la limite supérieure Amax est au plus égale à la distance L entre les deux butées, caractérisé par le fait que la translation alternative présente une amplitude totale décroissante, couvrant l'intervalle (L - Amax, L - Amin).

3 - Dispositif selon l'une des revendications 1 et 2, comprenant au moins une seconde paire de butées espacées, situées de part et d'autre de la pièce et agencées pour définir une seconde direction axiale non parallèle à celle qui passe par les premières butées, caractérisé par le fait que la composante selon la seconde direction axiale du mouvement imprimé à l'organe mobile est elle aussi une translation alternative, présentant une amplitude totale proche du jeu total de la pièce entre les deux butées de la seconde paire.

4 - Dispositif selon la revendication 3, dans lequel la pièce présente, dans la direction passant par les deux butées de la seconde paire, une dimension comprise dans un intervalle prédéterminé (Bmin, Bmax) dont la limite supérieure Bmax est au plus égale à la distance M entre les deux butées, caractérisé par le fait que la translation alternative présente dans la seconde direction une amplitude totale décroissante, couvrant l'intervalle (M - Bmax, M - Bmin).

5 - Dispositif selon l'une des revendications 2 et 4, caractérisé par le fait que l'amplitude totale de translation alternative décroît par pas inférieurs ou égaux à L - Amax.

6 - Dispositif selon l'une des revendications 1 à 5, caractérisé par le fait que l'organe mobile déplace finalement la pièce d'une distance prédéterminée pour l'amener à la position désirée.

7 - Dispositif selon l'une des revendications 1 à 6, caractérisé par le fait que l'organe mobile effectue ensuite un mouvement prédéterminé pour transférer la pièce à un autre emplacement, et que le point de prise initiale de l'organe mobile sur la pièce est choisi par référence aux butées d'après la position finale désirée de l'organe mobile sur la pièce.

8 - Dispositif selon l'une des revendications 1 à 7, caractérisé par le fait que l'organe mobile est d'un type capable de créer entre lui-même et la pièce une force non parallèle à la direction axiale, tel qu'une buse d'aspiration, une tête à électroaimant, ou une tête de gravité.

9 - Dispositif selon l'une des revendications 1 à 8, dans lequel les butées sont définies par les bords d'un alvéole de fond plat, logeant une pièce généralement plate, caractérisé par le fait que l'organe mobile s'applique sur la pièce avec une force non parallèle à la direction axiale, force que la pièce transmet au fond de l'alvéole, et par le fait que la surface du fond de l'alvéole est choisie pour avoir vis-à-vis de la pièce des caractéristiques de frottement inférieures à celles de l'organe mobile sur la pièce.

10 - Dispositif selon l'une des revendications 1 à 9, caractérisé par le fait que le moyen qui déplace l'organe mobile comprend au moins un moteur pas à pas et des moyens de commandes associés.

FIG.1

FIG.2

DIRECTION DE DÉPLACEMENT

DEPRESSION

FORCE APPLIQUÉE

20

13

16   17

12

-a   +a

3   y

11   14   15   x

-l   0   +l

0   z

1,(+np)

z₁

(-np)

3

-np   4

+np

t

1/1

0011020

Office européen
des brevets

**RAPPORT DE RECHERCHE EUROPEENNE**

EP 79 40 0783

| | **DOCUMENTS CONSIDERES COMME PERTINENTS** | | | CLASSEMENT DE LA DEMANDE (Int. Cl. ) |
|---|---|---|---|---|
| Categorie | Citation du document avec indication, en cas de besoin, des parties pertinentes | Revendica-tion concernee | | |
| A | <u>FR - A - 1 571 037</u> (IBM)<br>* Résumé; figure 1a * | 1-4,8 | | H 05 K 13/00<br>H 01 L 21/68<br>G 05 D 1/00 |
| | -- | | | |
| A | <u>FR - A - 2 128 293</u> (IBM)<br>* Revendications; figures 1,3,4 | 1,8 | | |
| | ---- | | | |

DOMAINES TECHNIQUES RECHERCHES (Int. Cl. )

H 05 K 13/00
H 01 L 21/68

CATEGORIE DES DOCUMENTS CITES

X: particulièrement pertinent

A: arriere-plan technologique

O: divulgation non-écrite

P: document intercalaire

T: théorie ou principe a la base de l'invention

E: demande faisant interference

D: document cite dans la demande

L: document cite pour d'autres raisons

&: membre de la même famille, document correspondant

Le present rapport de recherche a ete etabli pour toutes les revendications

| Lieu de la recherche | Date d achevement de la recherche | Examinateur |
|---|---|---|
| La Haye | 29-01-1980 | VAN REETH |

OEB Form 1503.1  06.78